# EUROPEAN PATENT SPECIFICATION

(11) **EP 0 472 654 B1**
(45) Date of publication and mention of the grant of the patent: **08.10.1997**
(21) Application number: 90908912.0
(22) Date of filing: 14.05.1990
(51) Int. Cl.: H01L 27/04, H01L 29/78, H01L 29/866

(54) **LOW VOLTAGE TRIGGERED SNAP-BACK DEVICE**
DURCH EINE NIEDRIGE SPANNUNG AUSLÖSBARE RÜCKSTELLUNGSANORDNUNG
DISPOSITIF DE RETOUR A ZERO DECLENCHE PAR DE FAIBLES TENSIONS

(30) Priority: 17.05.1989 GB 8911360; 08.05.1990 US 517891
(43) Date of publication of application: 04.03.1992
(73) Proprietor: Sarnoff Corporation, Princeton, New Jersey 08540 (US); SHARP CORPORATION, Tenri, Nara 632 (JP)
(72) Inventor: AVERY, Leslie, Ronald 565 Kingwood-Locktown Road, Hunterdon, NJ 08822 (US)
(74) Representative: Harris, Ian Richard
(86) International application number: US9002608
(87) International publication number: WO9015442

(56) References cited:
- EP-A- 0 162 460
- GB-A- 2 184 884
- JP-A-60 246 665
- JP-A-61 292 351
- US-A- 4 484 206

## Description

The present invention relates generally to protection devices, and more particularly to protection devices for protecting integrated circuits from various electrical transients, including electrostatic discharge (ESD).

Many attempts have been made in the prior art to protect semiconductor devices, including bipolar transistors, field effect devices, and integrated circuits against damage due to voltage and current transients. A particular problem with field effect devices has been their protection from electrostatic discharge (ESD).

Fischer, U.S. Patent No. 3,787,717, teaches the use of a lateral bipolar transistor for protecting a field effect device. The lateral bipolar transistor includes a gated collector junction, and has its collector-to-emitter current path shunting the point in the circuit to be protected against overvoltage. Metallization is placed over a silicon dioxide passivation layer covering the collector junction, and electrically connected to the point in the substrate to be protected. Similarly the emitter electrode is connected to the point to be protected. When an over voltage occurs, the gated collector junction breaks down in an avalanche mode, allowing current to flow therefrom to the substrate, causing a potential drop in the base region of the lateral transistor, in turn causing the latter to conduct for shunting away excess current due to the overvoltage condition.

Hartranft et al., U.S. Patent No. 4,605,980, teaches the use of a thick field effect transistor in combination with a thin field effect transistor to protect an integrated circuit, more specifically, to protect a field effect transistor from damage due to excessively high voltages and currents generated by electrostatic discharge. The protection circuit is formed on the same substrate and includes the a field effect transistor to be protected. A resistor-diode network is included in the circuitry for the thick field effect transistor. An elongated diffused resistor is included between an integrated circuit pad and the circuit to be protected. The thick field effect transistor is used to shunt high voltages and currents generated by electrostatic discharge away from the protected device, whereas the thin field effect transistor is used to protect against lower but still excessive voltages relative to the device being protected. There is no interaction between the thin and thick field effect transistors, other than each being employed for protecting a device over different ranges of voltage and current.

Rountree et al., U.S. Patent No. 4,692,781, teaches an input protection circuit for a field effect transistor using a thick oxide transistor for providing the main protection to the device. The thick oxide field effect device serves to protect the integrated circuit against relatively high voltages. A thin gate field effect transistor is used to provide low voltage protection, and serves as a "field plate diode".

Hartranft et al., U.S. Patent No. 4,745,450, teaches a circuit for protecting a thin gate oxide field effect transistor from puncture due to electrostatic discharge. The teachings of this invention are substantially similar to those of U.S. Patent No. 4,605,980.

Puar, U.S. Patent No. 4,786,956, discloses a device for protecting an integrated circuit from high input voltages, wherein the integrated circuit includes a semiconductor substrate with a recessed field-oxide region laterally separating active semiconductor portions. The protection device includes an N channel enhancement-mode field effect device having a source for receiving a first voltage, an insulated-gate electrode, and a drain electrode coupled to an input terminal, with the source and drain regions lying in one of the active portions along the upper surface of the substrate. A resistor is included for coupling the second voltage through the gate of the NMOS transistor. Another NMOS transistor, more specifically a thick-oxide device, has a source region lying in one of the active portions along the upper surface of the substrate coupled to the source of the first NMOS transistor, a gate electrode coupled to the input signal terminal, and a drain region lying in another of the active portions of the substrate along the upper surface thereof, that is also coupled to the input terminal.

Maloney, U.S. Patent No. 4,821,096, discloses a device for protecting a semiconductor device from voltage and current surges, such as caused by electrostatic discharge. The protection device or circuit includes a first PNP lateral transistor having an emitter region coupled to an input terminal of the device, a base region also connected to the input terminal, and a collector region coupled to ground. Further included is a second PNP lateral transistor having an emitter region coupled through a resistor to the input terminal, and base and collector regions coupled to ground. The protection device serves to shunt high voltage surges and current spikes to ground, away from the device being protected. Another embodiment of the invention includes a pair of P⁻ type field effect transistors in a similar configuration, for protecting a semiconductor device.

Duvvury et al., U.S. Patent No. 4,855,620, teaches the inclusion of a high threshold voltage field effect transistor for the active output transistor of a field effect transistor output buffer circuit. The high threshold voltage field effect device has its source-to-drain path connected between the power supply and the gate electrode of the output transistor. The high threshold voltage field effect device also has its gate connected to the output terminal of the output transistor. If an ESD transient occurs at the output terminal, the high threshold field effect device will conduct to protect the field effect transistor output buffer circuit, in that the former has a threshold voltage that is greater than the operating voltage of the output buffer, but less than the collector-base junction breakdown voltage of a parasitic bipolar transistor located in the output of the buffer circuit.

Patent abstracts of Japan, volume 11, No. 154 (E-508) [2601], May 1987 corresponding to Japanese application JP-A-61 292351 describes a protection circuit having a single MOS transistor with a single source region and a single drain region. The source region has a plurality of steps so that the length of the channel region between the source and drain regions varies across the transistor. The purpose of the stepped channel region is to distribute any surge voltage across the various portions of the channel region so that the surge voltage is dispersed by sharing in the channel length of the transistor.

European application EP-0 162 460 describes a protection device having an input MOS transistor and a protection MOS transistor. The protection MOS transistor has a single source region and a single drain region with a channel region therebetween. The channel length between essential portion of the device is longer than that at the ends of the device.

As very large scale integrated (VLSI) circuit geometries have continued to shrink, the decrease in the corresponding gate oxide thickness, relative to breakdown voltage, has been greater than the decrease in reverse junction breakdown of the typically available diffusions used to protect the oxide. At the one micrometer level, the difference in breakdown voltage is only a few volts. Also, the initial breakdown voltage of one of the commonly used structures, a thick oxide NMOS transistor snap-back device, is too high to provide protection of the related integrated circuit. Known protection circuits and devices are unable to meet the protection requirements for state-of-art VLSI devices.

In accordance with the invention there is provided a protection device for an integrated circuit connected to a bus and a reference line comprising: a substrate of a first conductivity type; a short channel length structure providing a first parasitic bipolar transistor having emitter and collector regions of a second conductivity type, opposite that of the first conductivity type, in the substrate and along its surface and laterally spaced by a base region, each of the collector and emitter regions being connected to a respective one of the bus and reference line such that the first parasitic bipolar transistor provides a main current conduction path between the bus and the reference line; and one or more longer channel length structures each providing a second parasitic bipolar transistor positioned in proximity to the first parasitic bipolar transistor and having emitter and collector regions of the second conductivity type, opposite that of the first conductivity type, in the substrate and along its surface and laterally spaced by a base region with the emitter and collector regions being separate from the emitter and collector regions of the first parasitic bipolar transistor, each of the collector and emitter regions of a said second parasitic bipolar transistor being connected to a respective one of the bus and reference line such that each said second parasitic bipolar transistor provides a main current conduction path between the bus and the reference line; wherein the first parasitic bipolar transistor has a breakdown voltage which is greater than a supply voltage for the integrated circuit and less than the breakdown voltage of the second parasitic bipolar transistor and the damage threshold of the integrated circuit; wherein the main current conduction path between the bus and the reference line provided by the first bipolar transistor has a relatively lower impedance than that of the integrated circuit when the first bipolar transistor is in a conduction state; and wherein current flow in the first parasitic bipolar transistor triggers the second parasitic bipolar transistor into conduction thereby substantially reducing the impedance of the second parasitic bipolar transistor's main current conduction path to below that of the first parasitic bipolar transistor's main current conduction path.

An embodiment of the invention therefore provides a structure for protecting an integrated circuit which can be fabricated on the same substrate as the integrated circuit. This includes a short channel length structure and a relatively longer channel length structure and a relatively longer channel length structure in which the short channel length structure is triggered into the conductive state at a relatively lower voltage than the longer channel length structure, whereby the short channel length structure drives the longer channel length structure into a conductive state, thereby provided rapid turn-on of the protection device over a very wide range of voltage and current. The longer channel length structure serves to conduct away substantially all of the transient energy from a transient phenomena such as ESD, with the short channel length structure serving to turn on at a relatively low voltage level, during the initial risetime of the transient phenomena. This insures that the longer channel length structure is triggered on in time to protect the integrated circuit device from the transient energy.

An embodiment of the invention is described hereinafter with reference to the accompanying drawings in which like items are identified by the same reference numeral and in which:
Figure 1 is a schematic plan top view of the layout of the structure for one embodiment of the invention;
Figure 2 is a cross section 2-2 of the structure of Figure 1;
Fig. 3 is a cross-sectional enlargement of the area or region within "A" of Fig. 2;
Fig. 4 is a cross section 4-4 of the structure of Fig. 1;
Fig. 5 is an enlarged cross section of the region or area "B" of Fig. 4;
Fig. 6 is a plan top view of the layout of the structure for one embodiment of invention;
Fig. 7 is a circuit schematic diagram showing the effective equivalent circuit for the protection device of Figs. 1-5.

An NMOS transistor incorporates a parasitic lateral bipolar NPN transistor. The parasitic lateral NPN transistor can be triggered into conduction when the collector-emitter breakdown voltage in the Vcer mode is exceeded. The P region (the substrate) of the NMOS transistor provides the base electrode of the parasitic lateral bipolar NPN transistor, which is normally connected to the associated emitter electrode (source of the NMOS transistor) a distance away from the actual base region. The substrate resistance forms an emitter-base shunt resistance. The NPN transistor may be fabricated without the NMOS gate electrode by using a thick field oxide to separate the two isolated N⁺ diffusions which form the collector and emitter regions. Typically, such an NPN transistor has a relatively wide base region, i.e. a relatively wide separation between collector and emitter regions. In order to reduce the initial breakdown voltage of the wide base region NPN transistor, it is necessary to use a narrower base region, i.e., use the parasitic NPN transistor of a short channel length NMOS transistor. However, such a device cannot absorb a large amount of energy without destruction of its associated gate insulator. The present inventor recognized that a structure which incorporates a short channel length structure to trigger a wide base region NPN transistor structure is required in protecting such devices. The short channel length structure has sufficient series resistance to prevent it from being damaged by transient voltages before the wide base region NPN transistor structure snaps back and conducts away the transient energy. It was further recognized that by providing a short channel length NMOS transistor preferably at the center, or near the center of, the protection device, for triggering a plurality of parasitic wide base region NPN transistor structures, within practical limits, enhanced protection from transient energy is provided for an associated integrated circuit.

In describing various embodiments of the invention, longer channel length structures comprise two relatively widely spaced regions of one conductivity type in a body of the opposite conductivity type, and short channel length structures are structures having narrowly spaced collector and emitter regions and breakdown voltages lower than those of the longer channel length structures.

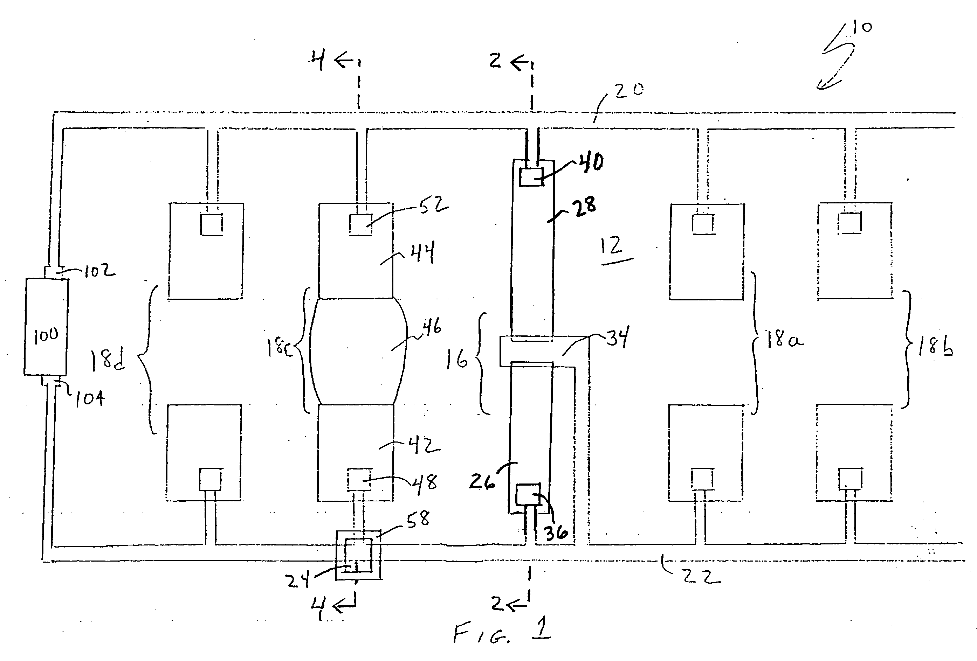

In Figs. 1 through 5, a structure 10 embodying the principles of the invention includes a semiconductor substrate 12, preferably of P⁻ type conductivity, having a surface 14. The structure also includes a short channel length structure 16, a plurality of longer channel length structures 18a-18d, a bus 20, a reference line 22 connected to a source of reference potential, typically ground, and a substrate contact 24 between the substrate 12 and the reference line 22.

Also in Fig. 1 the use of the structure 10 with an integrated circuit 100 to be protected is illustrated. The integrated circuit 100 has an electrode 102 connected to the bus 20 and an electrode 104 connected to the reference line 22 so that the integrated circuit 100 is connected in parallel with the short channel length structure 16 and the plurality of longer channel length structures 18a-18d. The first terminal 102 of the integrated circuit 100 may be a voltage supply terminal or an input or output signal terminal and the second terminal 106 can be a source of reference potential, typically ground. The protection device 102 protects the integrated circuit 100 by turning on in response to transient voltages and conducting transient energy from the bus 20 to the reference line 22.

The short channel length structure 16, as illustrated in Figs. 1-3, comprises first and second N⁺ conductivity type regions 26 and 28, corresponding to the emitter and collector regions respectively, extending a distance into the substrate 12 from the surface 30 and spaced apart from one another. A thin insulator layer 32, preferably a silicon oxide layer, overlies the surface 30. A gate electrode 34 overlies the thin insulator layer 32 over the spacing between the first and second N⁺ conductivity type regions 26 and 28. The gate electrode 34 is not typically required for the operation of the device and is present primarily to serve as the mask for use in the self-aligned process for the formation of the first and second N⁺ conductivity type regions 26 and 28 with a short, well defined channel length therebetween. If the gate electrode 34 is present, it is electrically connected to the reference line 22. A first electrical contact 36 extends through an opening 38 in the thin insulator layer 32 to provide electrical contact to the first N⁺ conductivity type region 26. The first electrical contact 36 extends to the reference line 22. A second electrical contact 40 extends through an opening 42 in the thin insulator layer 32 to provide electrical contact to the second N⁺ conductivity type region 28. The second electrical contact 40 extends to the bus 20.

An enlargement of the region "A" in Fig. 2 is shown in Fig. 3. Using a fabrication process with 1.25 micrometer design rules, the gate 34 is typically about 1.25 micrometers wide, the spacing between the N⁺ regions 26 and 28 is typically about one micrometer and is preferably reduced to the minimum allowed by the process used.

In Figs. 1 and 4-5, the longer channel length structure 18c comprises third and fourth N⁺ conductivity type regions 42 and 44, corresponding to the emitter and collector regions respectively, extending a distance into the substrate 12 from the surface 30 and spaced apart from one another. The insulator layer 32 overlies the surface 30 except over the spacing between the third and fourth N⁺ conductivity type regions 42 and 44. A field oxide region 46 is located between regions 42 and 44. The typical "bird's beak" 47, formed at either end of the field oxide 46, is typically about 0.5 micrometers in length. In a 1.25 micrometer design-rule fabrication process, the spacing between the third and fourth N⁺ conductivity type regions 42 and 44 is typically between about two and three micrometers. A third electrical contact 48 extends through an opening 50 in the thin insulator layer 32 to provide electrical contact to the third N⁺ conductivity type region 42. The third electrical contact 48 extends to the reference line 22. A fourth electrical contact 52 extends through an opening 54 in the thin insulator layer 32 to provide electrical contact to the fourth N⁺ conductivity type region 44. The fourth electrical contact 52 extends to the bus 20. An N-region 56 extends a distance into the substrate 12 from the surface 30 and from the fourth N⁺ conductivity type region 44. The function of the N- region 56 is to prevent metallic diffusion from the fourth electrical contact 52 into the substrate 12. A P⁺ region 58 extends a distance into the substrate 12 from the surface 30 a distance from the third N⁺ conductivity type region 42 and provides good electrical contact between the substrate 12 and the substrate contact 24.

The P- type conductivity substrate 12 is typically relatively lightly doped (about 10¹³/cc) and has a relatively low degree of conductivity. The N⁺ conductivity type regions are relatively heavily doped, typically about 10¹⁸/cc and have relatively high conductivity. The N- region 56 is relatively lightly doped, typically between about 10¹⁴/cc and 10¹⁵/cc and has a relatively low degree of conductivity. The P⁺ region 58 is relatively heavily doped and of relatively high conductivity. The electrical contacts, the bus and the reference line are typically composed of aluminum, molybdenum, other compatable metals, a silicide of or polysilicon or a combination of these materials.

Only one longer channel length structure is required for the operation of the invention but a plurality is preferred. The plurality of longer channel length structures, such as the four structures illustrated in Fig. 1, is typically positioned in proximity, and preferably positioned as close as permitted by the design rules for the fabrication process, to the short channel length structure 16.

The protection device of the invention is designed to breakdown and conduct at a voltage less than that which would cause damage to the integrated circuit and higher than the supply voltage of the integrated circuit. The protective device is designed to provide as closely as possible a short circuit between the bus 20 and the reference line 22 during the occurrence of a transient. In a typical application, the breakdown voltage for the short channel length structure 16 is about 8 volts and the breakdown voltage level for the longer channel length structure 18 is about 12 volts as compared to an integrated circuit supply voltage of about 5.5 volts. Accordingly, the protection device will not trigger at normal supply voltage levels. However, if a transient voltage occurs, the short channel length structure 16 will break down when the transient voltage exceeds 8 volts, causing base current to flow through the substrate 12. This current flow produces a voltage between the substrate 12 and the N⁺ region 42, leading to conduction and breakdown of the longer channel length structure 18 before the level of the transient voltage exceeds the damage threshold of the short channel length structure 16 and the circuit being protected. The longer channel length structure 18 typically turns on in about 1.0 to 1.5 nanoseconds after the the short channel length structure 16 begins to conduct.

During testing of engineering prototypes embodying the invention as shown in Fig. 1, it was discovered that current distribution at the ends of the protection structure was excessive. To insure that the distribution of current through the structure is such as to provide for an even distribution of current flow in all of the longer channel length structures 18, the N⁺ diffusion was increased for those longer channel length structures 18 farthest removed from the short channel length structure 16 to provide for resistive ballasting.

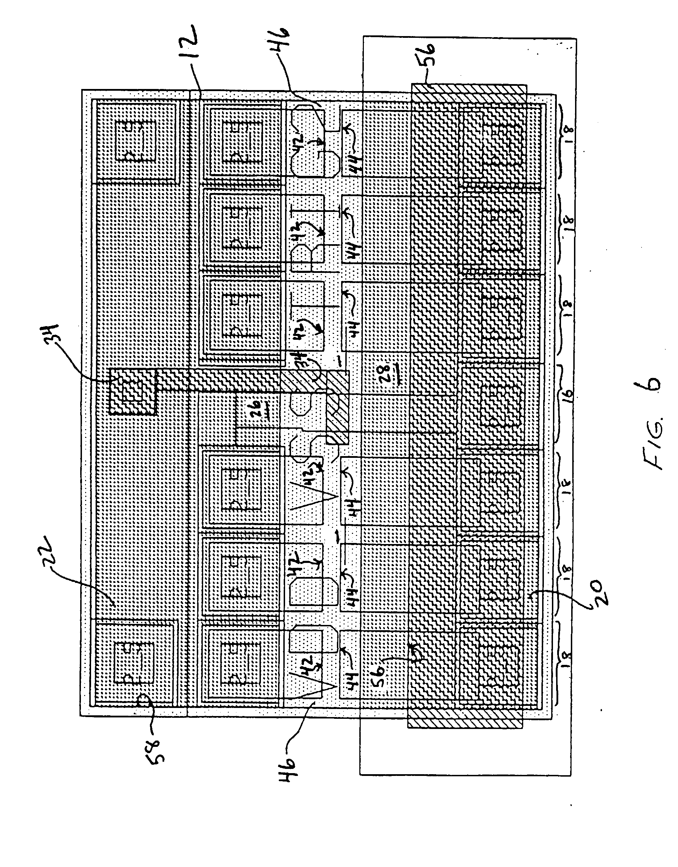

A top view of the layout of the structure of the invention as illustrated in Figs. 1-5 is shown in Fig. 6 where the identifying numbers are the same as those of Figs. 1-5. As shown, six longer channel length structures 18 are connected in parallel, about a centrally located short channel length structure 16.

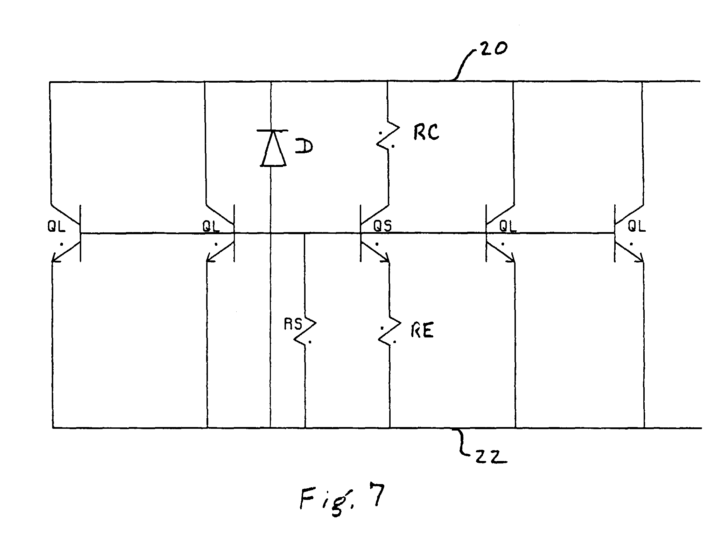

In Fig. 7, the effective equivalent circuit of the protection device of Figs. 1-5 includes a parasitic NPN transistor QS provided by the short channel length structure 16 and a plurality of parasitic NPN transistors QL provided by the plurality of longer channel length structures 18. The collector and emitter resistors RC and RE, respectively, are provided by the parasitic elements of the short channel length structure 16. The substrate resistance provides the emitter-base shunt resistance RS. The NPN transistor QS has its collector electrode connected to bus 20 through collector resistor RC and its emitter electrode connected to the reference line 22 through emitter resistor RE, and its base electrode connected in common with the base electrode of NPN transistor QL via the common substrate 12 and through emitter-base shunt resistance RS to the reference line 22.

The collector and emitter resistors RC and RE limit the current flow through NPN transistor QS thereby protecting the short channel length structure from high voltage transients. Once the parasitic NPN transistors QL are triggered into conduction by NPN transistor QS, the transistors QL will rapidly go into the snap-back mode of conduction, thereby conducting away the transient energy. The critical current necessary for snap-back to occur in an NPN transistor QL is about five microamperes/ micrometer. Accordingly, as soon as base current begins to flow in transistor QS, base current also flows in the parasitic NPN transistor QL. Due to the current limiting effect of resistors RC and RL, the majority of the current flows through QL, which snaps-back when the magnitude of current therethrough exceeds the snap-back threshold for the structure.

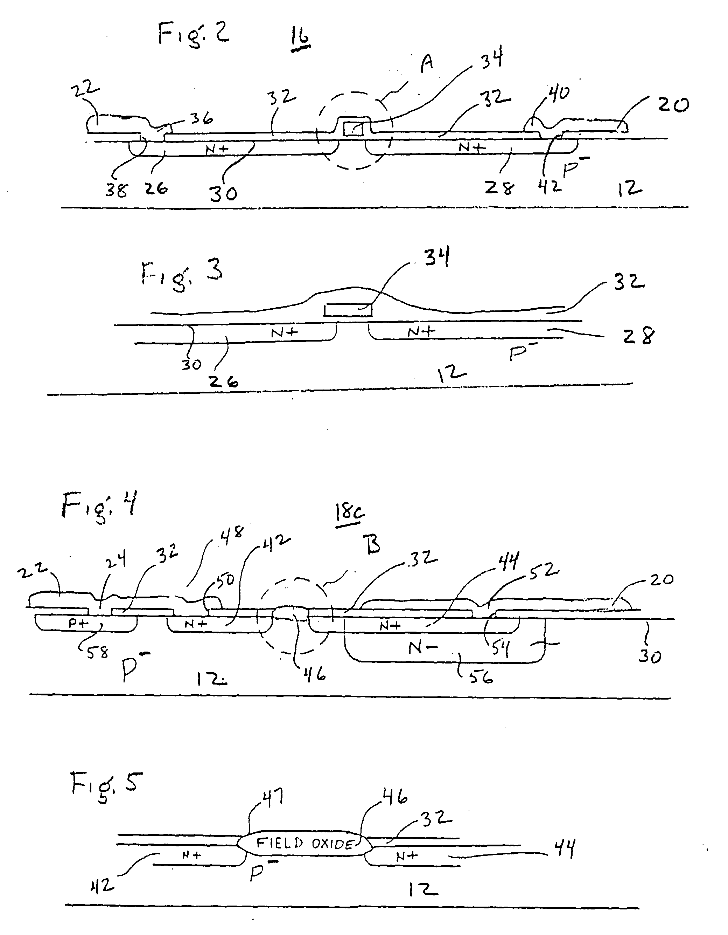

A parasitic diode D, formed between the P⁺ region 58 and the N⁺ region 28 shown in Fig. 2 and between the P⁺ region 58 and the N⁺ region 44 shown in Fig. 5, permits the reverse flow of transient current from the reference line 22 to the bus 20.

The devices of the invention may be fabricated utilizing standard photolithographic and etching steps for definition and ion implantation for forming the doped regions. Typically, a silicon semiconductor substrate is used with, for example, boron as a P type dopant and phosphorus as an N type dopant, but other suitable materials may be used. The insulators are typically a silicon oxide or a nitride formed using techniques well known in the art.

Modifications of the various embodiments of the invention may occur to one skilled in the art. For example, while the invention has been described in terms of particular conductivity types, converse conductivity types may be used so long as the relative conductivity types remain the same.

## Claims

1. A protection device (10) for an integrated circuit (100) connected to a bus (20) and a reference line (22) comprising:
a substrate (12) of a first conductivity type;
a short channel length structure (16) providing a first parasitic bipolar transistor having emitter and collector regions (26, 28) of a second conductivity type, opposite that of the first conductivity type, in the substrate and along its surface and laterally spaced by a base region, each of the collector and emitter regions being connected to a respective one of the bus and reference line such that the first parasitic bipolar transistor provides a main current conduction path between the bus and the reference line; and
one or more longer channel length structures (18a, 18b, 18c, 18d), each providing a second parasitic bipolar transistor positioned in proximity to the first parasitic bipolar transistor and having emitter and collector regions (42, 44) of the second conductivity type, opposite that of the first conductivity type, in the substrate and along its surface and laterally spaced by a base region with the emitter and collector regions being separate from the emitter and collector regions of the first parasitic bipolar transistor, each of the collector and emitter regions of a said second parasitic bipolar transistor being connected to a respective one of the bus and reference line such that each said second parasitic bipolar transistor provides a main current conduction path between the bus and the reference line;
wherein the first parasitic bipolar transistor has a breakdown voltage which is greater than a supply voltage for the integrated circuit and less than the breakdown voltage of the second parasitic bipolar transistor and the damage threshold of the integrated circuit;
wherein the main current conduction path between the bus and the reference line provided by the first bipolar transistor has a relatively lower impedance than that of the integrated circuit when the first bipolar transistor is in a conduction state; and
wherein current flow in the first parasitic bipolar transistor triggers the second parasitic bipolar transistor into conduction thereby substantially reducing the impedance of the second parasitic bipolar transistor's main current conduction path to below that of the first parasitic bipolar transistor's main current conduction path.

2. The device of claim 1, wherein the second parasitic bipolar transistor comprises:
a field oxide region (46) overlying the surface between the emitter and collector regions.

3. The device of claim 2, wherein the field oxide region has each of its ends partially juxtaposed to a portion of the emitter and collector region, respectively, and physically separates and electrically isolates the emitter and collector regions from one another.

4. The device of claim 3, wherein the first parasitic bipolar transistor includes a collector electrode connected between the collector region and the bus (20), an emitter electrode connected between the emitter region and the reference line (22), and a base electrode, and each second parasitic bipolar transistor includes a base electrode connected the base electrode of the first parasitic bipolar transistor, a collector electrode connected to the collector region of the second parasitic bipolar transistor and to the bus, and an emitter electrode connected to the emitter region of the second parasitic bipolar transistor and the reference line.

5. The device of claim 4, further including a first parasitic resistor (RC) connected between the collector electrode of the first bipolar transistor and the bus, and a second parasitic resistor (RE) connected between the emitter electrode of the first parasitic bipolar transistor and the reference line.

6. The device of claim 5, further comprising a thin insulator layer overlying the surface over and between the emitter and collector regions of the first parasitic bipolar transistor.

7. The device of claim 6, wherein a gate electrode overlies the thin insulator layer over the spacing between the emitter and collector regions of the first parasitic bipolar transistor.

8. The device of claim 7, further including a diode having a cathode electrode connected to the bus, and an anode electrode connected to the reference line, for providing a current conduction path between the reference line and the bus.

## Patentansprüche

1. Schutzeinrichtung (10) für einen integrierten Schaltkreis (100), der mit einem Bus (20) und einer Bezugsleitung (22) verbunden ist, mit:
einem Substrat (12) eines ersten Leitfähigkeitstyps,
einem Aufbau (16) aus einem kurzen Kanalabschnitt, welcher einen ersten, bipolaren Störspannungstransistor bereitstellt, der Emitter- und Kollektorbereiche (26, 28) eines zweiten Leitfähigkeitstyps hat, der der zu dem ersten entgegengesetzte Leitfähigkeitstyp ist, und zwar in dem Substrat und entlang dessen Oberfläche und seitlich beabstandet durch einen Basisabschnitt, wobei sowohl der Kollektor- als auch der Emitterbereich jeweils mit einer der Leitungen, nämlich der Busleitung und der Bezugsleitung verbunden ist, so daß der erste, bipolare Störspannungstransistor einen Hauptstromleitpfad zwischen dem Bus bzw. der Busleitung und der Bezugsleitung bereitstellt, und
einem oder mehreren Aufbauten (18a, 18b, 18c, 18d) aus einem längeren Kanalabschnitt, die jeweils einen zweiten, bipolaren Störspannungstransistor bereitstellen, der in der Nähe zu dem ersten bipolaren Störspannungstransistor angeordnet ist und Emitter- und Kollektorbereiche (42, 44) des zweiten Leitfähigkeitstyps hat, welcher dem ersten Leitfähigkeitstyp entgegengesetzt ist, und zwar in dem Substrat und entlang dessen Oberfläche, und seitlich beabstandet durch einen Basisbereich, wobei die Emitter- und Kollektorbereiche von den Emitter- und Kollektorbereichen des ersten bipolaren Störspannungstransistors getrennt sind, wobei jeder der Kollektor- und Emitterbereiche des zweiten bipolaren Störspannungstransistors jeweils mit einer der Leitungen, nämlich der Busleitung und der Bezugsleitung derart verbunden ist, daß jeder der zweiten, bipolaren Störspannungstransistoren einen Hauptstromleitungspfad zwischen der Busleitung und der Bezugsleitung bereitstellt,
wobei der erste bipolare Störspannungstransistor eine Durchbruchspannung hat, die größer ist als eine Versorgungsspannung für den integrierten Schaltkreis und niedriger ist als die Durchbruchspannung der zweiten bipolaren Störspannungstransistoren und der Beschädigungsgrenzwert des integrierten Schaltkreises,
wobei der Hauptstromleitpfad zwischen der Busleitung und der Bezugsleitung, welcher durch den ersten bipolaren Transistor bereitgestellt wird, eine vergleichsweise geringere Impedanz hat als der integrierte Schaltkreis, wenn der erste bipolare Transistor sich in einem leitfähigen Zustand befindet, und
wobei der Stromfluß in dem ersten bipolaren Störspannungstransistor den zweiten bipolaren Störspannungstransistor in den leitenden Zustand schaltet, um dadurch die Impedanz des Hauptstrompfades des zweiten bipolaren Störspannungstransistors unter die des Stromleitpfades des ersten bipolaren Störspannungstransistors zu vermindern.

2. Einrichtung nach Anspruch 1, wobei der zweite bipolare Störspannungstransistor aufweist:
einen Feldoxidbereich (46), welcher die Oberfläche zwischen den Emitter- und Kollektorbereichen überdeckt.

3. Einrichtung nach Anspruch 2, wobei der Feldoxidbereich mit jedem seiner Enden teilweise einem Abschnitt des Emitter- bzw. Kollektorbereiches gegenüberliegt und die Emitter- und Kollektorbereiche räumlich trennt und elektrisch voneinander isoliert.

4. Einrichtung nach Anspruch 3, wobei der erste, bipolare Störspannungstransistor eine Kollektorelektrode einschließt, die zwischen den Kollektorbereich und die Busleitung (20) geschaltet ist, eine Emitterelektrode, die zwischen den Emitterbereich und die Bezugsleitung (22) geschaltet ist, und eine Basiselektrode, die mit der Basiselektrode des ersten bipolaren Störspannungstransistors verbunden ist, wobei eine Kollektorelektrode mit dem Kollektorbereich des zweiten bipolaren Störspannungstransistors und der Busleitung verbunden ist und eine Emitterelektrode mit dem Emitterbereich des zweiten, bipolaren Störspannungstransistors und der Bezugsleitung verbunden ist.

5. Einrichtung nach Anspruch 4, welche weiterhin einen ersten Störspannungswiderstand (RC) aufweist, der zwischen die Kollektorelektrode des ersten bipolaren Transistors und die Busleitung geschaltet ist, sowie einen zweiten Störspannungswiderstand (RE) aufweist, der zwischen die Emitterelektrode des ersten bipolaren Störspannungstransistors und die Bezugsleitung geschaltet ist.

6. Einrichtung nach Anspruch 5, welche weiterhin eine dünne Isolatorschicht aufweist, welche die Oberfläche über und zwischen den Emitter- und Kollektorbereichen des ersten bipolaren Störspannungstransistors abdeckt.

7. Einrichtung nach Anspruch 6, wobei eine Gatterelektrode auf der Isolierschicht über dem Zwischenraum zwischen den Emitter- und Kollektorbereichen des ersten bipolaren Störspannungstransistors liegt.

8. Einrichtung nach Anspruch 7, welche weiterhin eine Diode einschließt, die eine Kathodenelektrode hat, welche mit der Busleitung verbunden ist, sowie eine Anodenelektrode, die mit der Bezugsleitung verbunden ist, um einen Stromleitungspfad zwischen der Bezugsleitung und der Busleitung bereitzustellen.

## Revendications

1. Dispositif de protection (10) pour un circuit intégré (100) connecté à un bus (20) et à une ligne de référence (22), comprenant :
un substrat (12) d'un premier type de conductivité ;
une structure en longueur (16), à canal court, créant un premier transistor bipolaire parasite, ayant des zones (26, 28) d'émetteur et de collecteur d'un second type de conductivité, opposé au premier type de conductivité, dans le substrat et le long de sa surface, et espacées latéralement par une zone de base, chacune des zones de collecteur et d'émetteur étant connectée à l'un, respectif, du bus et de la ligne de référence, de façon telle que le premier transistor bipolaire parasite crée un chemin principal de conduction de courant entre le bus et la ligne de référence ; et
une ou plusieurs structures en longueur (18a, 18b, 18c, 18d), à canal plus long, chacune créant un second transistor bipolaire parasite placé à proximité du premier transistor bipolaire parasite et ayant des zones (42, 44) d'émetteur et de collecteur du second type de conductivité, opposé au premier type de conductivité, dans le substrat et le long de sa surface, et espacées latéralement par une zone de base, les zones d'émetteur et de collecteur étant distinctes des zones d'émetteur et de collecteur du premier transistor bipolaire parasite, chacune des zones de collecteur et d'émetteur dudit second transistor bipolaire parasite étant connectée à l'un, respectif, du bus et de la ligne de référence, de façon telle que chacun desdits seconds transistors bipolaires parasites crée un chemin principal de conduction de courant entre le bus et la ligne de référence ;
dans lequel le premier transistor bipolaire parasite a une tension de claquage qui est plus grande qu'une tension d'alimentation pour le circuit intégré et plus petite que la tension de claquage du second transistor bipolaire parasite et que le seuil d'endommagement du circuit intégré ;
dans lequel le chemin principal de conduction de courant entre le bus et la ligne de référence, créé par le premier transistor bipolaire, a une impédance relativement plus basse que celle du circuit intégré lorsque le premier transistor bipolaire est dans un état de conduction ; et
dans lequel l'écoulement de courant dans le premier transistor bipolaire parasite déclenche le second transistor bipolaire parasite en conduction en réduisant ainsi sensiblement l'impédance du chemin principal de conduction de courant de second transistor bipolaire parasite pour qu'il soit inférieur à celui du chemin principal de conduction de courant de premier transistor bipolaire parasite.

2. Dispositif selon la revendication 1, dans lequel le second transistor bipolaire parasite comprend :
une zone (46) d'oxyde de champ recouvrant la surface entre les zones d'émetteur et de collecteur.

3. Dispositif selon la revendication 2, dans lequel la zone d'oxyde de champ a chacune de ses extrémités partiellement juxtaposées, respectivement, à une partie de la zone d'émetteur et de la zone de collecteur, et sépare physiquement et isole électriquement les zones d'émetteur et de collecteur l'une de l'autre.

4. Dispositif selon la revendication 3, dans lequel le premier transistor bipolaire parasite inclut une électrode de collecteur connectée entre la zone de collecteur et le bus (20) ; une électrode d'émetteur connectée entre la zone d'émetteur et la ligne de référence (22) ; et une électrode de base, et dans lequel chaque second transistor bipolaire parasite inclut une électrode de base connectée à l'électrode de base du premier transistor bipolaire parasite ; une électrode de collecteur connectée à la zone de collecteur du second transistor bipolaire parasite et au bus ; et une électrode d'émetteur connectée à la zone d'émetteur du second transistor bipolaire parasite et à la ligne de référence.

5. Dispositif selon la revendication 4, incluant en outre une première résistance parasite (RC) connectée entre l'électrode de collecteur du premier transistor bipolaire et le bus, et une seconde résistance parasite (RE) connectée entre l'électrode d'émetteur du premier transistor bipolaire parasite et la ligne de référence.

6. Dispositif selon la revendication 5, comprenant en outre une couche isolante mince recouvrant la surface sur et entre les zones d'émetteur et de collecteur du premier transistor bipolaire parasite.

7. Dispositif selon la revendication 6, dans lequel une électrode de grille recouvre la couche isolante mince sur l'espace entre les zones d'émetteur et de collecteur du premier transistor bipolaire parasite.

8. Dispositif selon la revendication 7, incluant en outre une diode dont l'électrode de cathode est connectée au bus, et dont l'électrode d'anode est connectée à la ligne de référence, pour créer un chemin de conduction de courant entre la ligne de référence et le bus.
